Europäisches Patentamt

European Patent Office

Office européen des brevets

(19)

(11) Publication number: **0 334 638**
**A1**

## EUROPEAN PATENT APPLICATION

(12)

(21) Application number: **89302855.5**

(22) Date of filing: **22.03.89**

(51) Int. Cl.⁴: **C 23 C 16/50**
**H 01 J 37/32**

(30) Priority: **22.03.88 JP 67570/88**
**24.05.88 JP 127579/88**
**24.05.88 JP 127580/88**

(43) Date of publication of application:
**27.09.89 Bulletin 89/39**

(84) Designated Contracting States: **DE FR GB**

(71) Applicant: **SEMICONDUCTOR ENERGY LABORATORY
CO., LTD.**
**398 Hase**
**Atsugi-shi Kanagawa-ken, 243 (JP)**

(72) Inventor: **Yamazaki, Shunpei**
**21-21 Kitakarasuyama 7-chome**
**Setagaya-ku Tokyo (JP)**

**Imatou, Shinji**
**Flat Atsugi 303, 931-1 Hase**
**Atsugi-shi Kanagawa-ken (JP)**

**Ishida, Noriya**
**Flat Atsugi 207, 931-1 Hase**
**Atsugi-shi Kanagawa-ken (JP)**

**Sakama, Mitsunori**
**Kamiyoshizawa 1173**
**Hiratsuka-shi Kanagawa-ken (JP)**

**Sasaki, Mari**
**Flat SEL 303, 304-1 Hase**
**Atsugi-shi Kanagawa-ken (JP)**

**Fukada, Takeshi**
**3-31, Sugikubo 2589**
**Ebina-shi Kanagawa-ken (JP)**

**Hirose, Naoki**
**931-1 Hase**
**Atsugi-shi Kanagawa-ken (JP)**

**Tsuchiya, Mitsunori**
**1-2-3 Ouji**
**Atsugi-Shi Kanagawa-ken (JP)**

**Kawano, Atsushi**
**28-28 Nurumizu**
**Atsugi-shi Kanagawa-ken (JP)**

**Nakashita, Kazuhisa**
**Flat SEL 205, 304-1 Hase**
**Atsugi-shi Kanagawa-ken (JP)**

**Takeyama, Junichi**
**Flat SEL 102, 304-1 Hase**
**Atsugi-shi Kanagawa-ken (JP)**

**Hamatani, Tohiji**
**987-4 Hase**
**Atsugi-shi Kanagawa-ken (JP)**

(74) Representative: **Milhench, Howard Leslie et al**
**R.G.C. Jenkins & Co. 26 Caxton Street**
**London SW1H 0RJ (GB)**

(54) Improvements relating to the formation of thin films.

(57) An improved apparatus and method for depositing thin films on a substrate by means of a CVD process is disclosed. The apparatus utilizes two types of energy input. A pair of electrodes are provided in a reaction chamber and are supplied with AC electrical energy at a frequency of from 1 to 5000 MHz for generating a plasma gas in a reaction space defined therebetween. The substrate is mounted within the reaction space on a substrate holder which is energized from a second electrical energy source at a frequency of from 1 to 500 KHz. The invention enables the deposition by a CVD process of films of carbon possessing advantageous features particularly as regards hardness characteristics, and also enables the deposition of such other materials as silicon nitride and other nitrides.

FIG.2

Description

## Improvements Relating to the Formation of Thin Films

### BACKGROUND OF THE INVENTION

This invention concerns improvements relating to the formation of thin films and more particularly relates to an apparatus and a method for forming thin films in quantity.

Recently, ECR (Electron Cyclotron Resonance) enhanced CVD (Chemical Vapour Deposition) has attracted the interest of researchers as a new method of manufacturing thin films, particularly amorphous thin films. For example, Matsuo et al discloses one type of such an ECR CVD apparatus in US Patent No. 4,401,054. This recent technique utilizes microwave energy to energize a reactive gas such that it develops into a plasma. A magnetic field functions to pinch the plasma gas within the excitation space. Within this excitation space, the reactive gas can absorb the microwave energy. A substrate to be coated is spaced apart from the excitation space (resonating space) to prevent the same from being sputtered, and the energized gas is showered onto the substrate from the resonating space. In order to establish electron cyclotron resonance the pressure in the resonating space is kept at $1 \times 10^{-5}$ Torr; at this pressure electrons can be considered as independent particles and resonate with the microwave energy in an electron cyclotron resonance where the magnetic field strength meets the requirements for ECR. The excited plasma is extracted from the resonating space by means of a divergent magnetic field and is conducted to a deposition space which is spaced apart from the resonating space and in which there is disposed a substrate to be coated.

It is very difficult to perform deposition of a polycrystalline or single-crystalline carbon structure by such a prior art method, so that currently available methods are substantially limited to processes for manufacturing amorphous films. Also, high energy chemical vapor reactions cannot readily be accomplished by such a prior art method and therefore it has not been possible to form diamond films or other films having high melting points, or to form uniform films on a surface having depressions and hollows. Furthermore, it has been impossible to coat the surface of a super hard material such as tungsten carbide with a carbon film and, because of this, it has been necessary to coat such a super hard surface with fine diamond powder in order to obtain an abrasive which has a sufficient degree of hardness and this has given rise to problems of making sturdy mechanical contact between the diamond powder and the substrate surface.

### OBJECTS AND SUMMARY OF THE INVENTION

It is therefore an object of the present invention to provide an improved plasma CVD apparatus and fabrication method for the production of thin films.

It is another object of the present invention to provide a method and apparatus for the production of carbon films having high adhesivity to the underlying substrate.

It is a further object of the present invention to provide an improved thin film method and apparatus which is suitable for mass production.

According to the present invention in one of its aspects there is provided a plasma processing apparatus comprising: a reaction chamber; a reactive gas supply system; a vacuum pump for evacuating said reaction chamber; spaced-apart electrodes provided in said reaction chamber in order to define a reaction space therebetween; a substrate holder provided in said reaction space; a first power source for applying AC electrical energy between said electrodes at a frequency for encouraging the generation of a plasma gas therebetween; and a second power source for applying AC electrical energy to said substrate holder.

According to another aspect the present invention provides a method of depositing a thin film coating on a substrate, said method comprising: disposing a substrate to be coated in a vacuum chamber; introducing a reactive gas into said vacuum chamber at an appropriate pressure; producing a plasma gas in said reaction chamber by applying high frequency energy to spaced-apart electrodes between which said substrate has been disposed; applying alternating electrical energy to said substrate; and depositing the product of said reactive gas on said substrate by virtue of said alternating electrical energy.

In accordance with an embodiment of the invention as hereinafter described AC electric energy is applied at a frequency of from 1 to 5000 MHz to a pair of electrodes in a CVD chamber in order to generate a plasma gas therebetween. AC electrical energy is also applied to a substrate at a frequency of from 1 to 500 KHz for collecting excited gas and eliminating undesirable charges stored thereon. The reactive gas used may be, for example, a hydrocarbon such as $C_2H_2$, $C_2H_4$, $C_2H_6$, $CH_3OH$, $C_2H_5OH$ or $CH_4$ and a halogen compound gas such as $CF_4$, $C_2F_2$, $C_2F_4$, $C_2Cl_2$ or $C_2Cl_4$. By means of this process, insulating carbon films having an energy gap not less than 1.0 eV and typically from 1.5 to 5.5 eV can be deposited. When silicon nitride films are deposited in accordance with the teachings of the present invention, the resistivity of the films ranges from 1.7 ohm centimeter to 2.0 ohm centimeter. The etch rate of the silicon nitride films by HF is 2 to 10 Å/sec, whereas for silicon nitride films deposited by prior art methods etch rates of the order of 30 Å/sec. are obtained.

Further features of the invention are set forth in the dependent claims and, together with the abovementioned features, will become clearly understood by consideration of the following detailed description given with reference to the accompanying drawings.

## BRIEF DESCRIPTION OF THE DRAWINGS

Fig.1(A) is a schematic showing of an exemplary plasma CVD apparatus in accordance with the present invention;

Fig.1(B) is a cross-sectional view taken along line A-A' of Fig.1(A); and

Fig.2 is a schematic showing of another exemplary plasma CVD apparatus in accordance with the present invention.

## DETAILED DESCRIPTION OF THE EMBODIMENTS

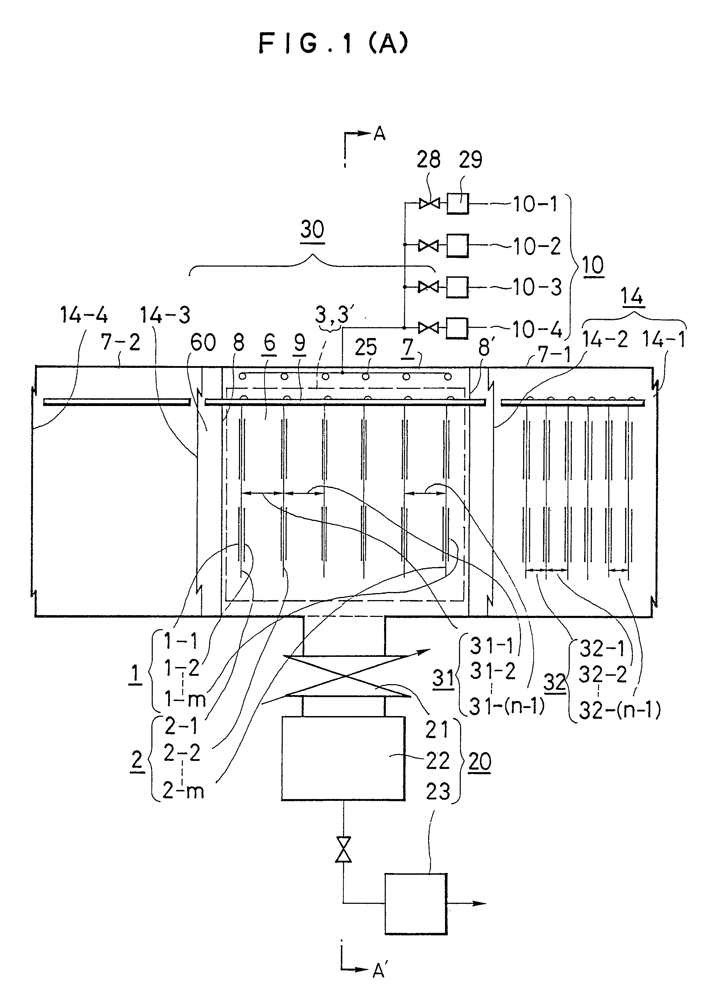

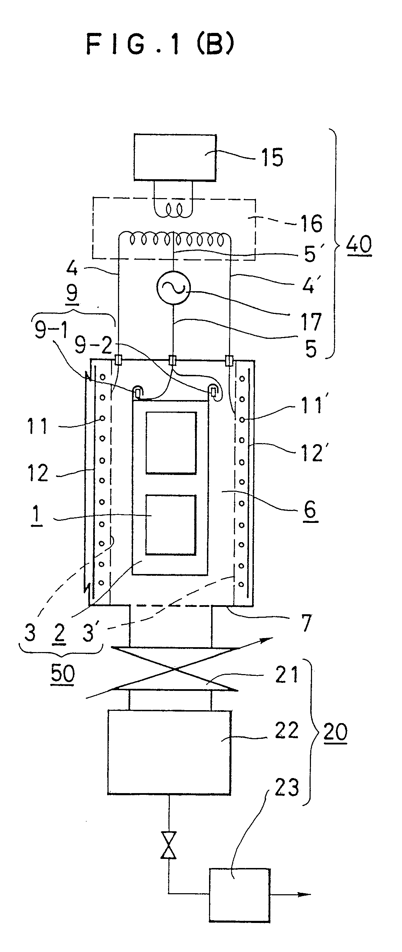

Referring to Figs.1(A) and 1(B), a plasma CVD apparatus in accordance with the present invention will now be described. A large size plasma treatment system comprises a reaction chamber 7 provided with a loading chamber 7-1, an unloading chamber 7-2, a pair of guide rails 9 for suspending a plurality of substrate holders 2 in the form of aluminium or nickel plates, a high frequency electric power source 15 for supplying electric power through a matching transformer 16, first and second metallic mesh electrodes 3 and 3' connected to the output terminals 4 and 4' of the transformer 16, the geometric area of each electrode being 150 cm² and the effective area of each electrode being 120 cm², an alternating electric power source 17 connected between the midpoint of the secondary coil of the transformer and the guide rails 9, a gas supply system 10 consisting of four supply passages each of which is provided with a flow meter 29 and a valve 28, a nozzle 25 tor inputting gases to the reaction chamber 7 from the gas supply system 10, and an exhaust system 20 including a pressure control valve 21, a turbomolecular pump 22 and a rotary pump 23.

A reaction space is defined within the reaction chamber by a four-sided hollow structure 8 and 8' of 160 cm width, 40 cm depth and 160 cm height for preventing deposition of reaction products on the inside wall of the reaction chamber 7. The height of the hollow structure may be chosen between 20 cm and 5 m in general. One dimension of the electrodes 3 and 3' may be chosen between 30 cm and 3 m in general. Gate valves 14-1 and 14-4 are provided between the exterior of the reaction chamber system and the loading and unloading chambers 7-1 and 7-2 respectively, and gate valves 14-2 and 14-3 are provided between the reaction chamber 7 and the loading and unloading chambers 7-1 and 7-2 respectively. The inside of the reaction chamber 7 is provided with a heater consisting of a plurality of halogen lamps 11 and 11' and reflective plates 12 and 12' behind the lamps.

A plurality of substrates 1-1, 1-2, ..1-n are mounted on the plurality of substrate holders 2-1, 2-2, ...2-n. The distances 31-1, 31-2, ..31-n between adjacent holders in the reaction chamber 7 are arranged to be substantially constant to within ±20%. The corresponding distances in the loading chamber are smaller for the purpose of designing a compact system. In this arrangement, only one side surface of each substrate is required to be coated. If coating of both surfaces is desired, the substrates can be supported in openings formed in the holders.

Introduced into the reaction chamber 7 is a carrier gas of argon or hydrogen supplied from the passage 10-1 of the gas feeding system, a reactive gas comprising a hydrocarbon such as methane or ethylene supplied from the passage 10-2, and a halogen compound gas such as $NF_3$ supplied from the passage 10-3. The pressure of the reactive gas is 0.001 to 1.0 Torr, e.g. 0.05 Torr. The substrate temperature may be-100°C (in the case where a cooling system is provided) or may be up to 150°C.

A first alternating voltage is applied between the mesh electrodes 3 and 3 at a high frequency of 1 MHz to 5 GHz, e.g. 13.56 MHz, while a second alternating voltage is applied between the midpoint of the secondary coil and the rails 9 at a frequency of 1 KHz to 500 KHz, e.g. 50 KHz. The input power of the first alternating voltage is 1.0 KW to 30 KW (equivalent to a plasma energy of 0.04-1.3 KW/cm²), e.g. 10 KW (equivalent to a plasma energy of 0.44W/cm²). The second alternating voltage functions to apply an AC bias voltage of -200 to 600 V (equivalent to 500W) at the substrate surfaces. By virtue of this injection of electric power, a plasma is generated in the reaction chamber 7 and initiates a chemical vapor reaction. Exhausted gas is removed through the evacuation system 20.

In operation of the apparatus to deposit carbon coatings, first argon gas was introduced into the reaction chamber at 0.05 Torr, followed by the application of a high frequency voltage between the mesh electrodes 3 and 3' at 110 KW from the power source 15 and between the transformer 16 and the substrate holders 2 in order to effect sputtering action until the substrate temperature reached 100 to 500°C. Then, methane was continuously introduced in order that methane gradually substituted for and finally replaced all of the argon. As a result, carbon coatings (amorphous or crystalline) were obtained. The Vickers hardness of the coatings was measured and found to be not lower than 2000 Kg/mm². The thermal conductivity of the coatings was measured and found to be not lower than 2.5 W/cm deg. The deposition speed was 100 to 1000 Å/min, e.g. 100 to 200 Å/min. In the case of the deposition of coatings having a thickness of 1 micron at the centres of the substrates, the thickness of the coatings was uniform to within 10%. also, the physical properties of the coatings, such as hardness, were substantially uniform.

Next, there will be described the formation of a final coating on a silicon semiconductor wafer within which semiconductor devices are formed in order to define a plurality of IC chips. After providing Al wiring on the wafer, a silicon oxide film is deposited to a thickness of 0.3 to 1 microns by use of the apparatus shown in Figs 1(A) and 1(B). A carbon coating is then deposited to a thickness of 0.1 to 1 micron on the silicon oxide film. The upper surface of the carbon film is then covered with an organic photoresist pattern, and the carbon film and the silicon oxide film are selectively removed by use of HF etchant in order to expose the bonding pads of the wiring. The organic resist is removed by use of oxygen or a suitable oxygen compound as an etchant.

In the same manner, it is possible to deposit silicon nitride films using silane and ammonia, boron nitride films using diborane and ammonia, titanium nitride films using organic titanium and nitrogen, and aluminium films using methylaluminium.

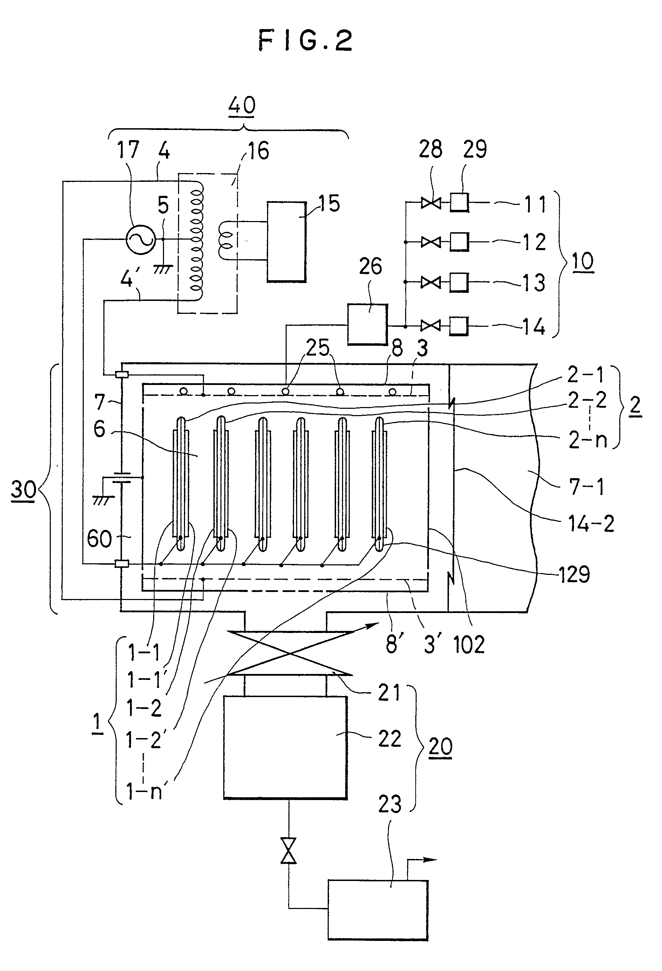

Referring to Fig.2, another embodiment of the invention is illustrated. The apparatus shown in Fig.2 is constructed on the basis of the same conception as the previous embodiment. Like numerals are given to like parts appearing in the figures of both embodiments and redundant explanation will not be repeated.

In contrast to the previous embodiment, Al mesh electrodes 3 and 3' are provided above and below the substrates 1 to be coated. The substrates 1 are mounted on a plurality of substrate holders 2 which are coated with alumina films 129 by alumite treatment. The alumina films insulate the substrates from the substrate holders 2. Alternating current, however, can pass through the alumina films. Two substrates are mounted on both sides of each holder 2. Enclosing the substrate array, a circular or rectangular cylinder 102 is provided. The height, width and length of the rectangular cylinder are 20 to 100 cm, e.g. 40 cm, 30 to 300 cm, e.g. 80 cm, and 30 to 300 cm, e.g. 80 cm respectively. The upper and lower openings of the cylinder are closed by lids 8 and 8' in which the electrodes 3 and 3 are fixed. A high frequency power source 15 and an alternating power source 17 are of the same structure as those of the previous embodiment. The alternating power source 17 is connected between the substrate holders 2 and ground 5.

In operation of the Fig.2 embodiment, after evacuating the reaction chamber 7, reactive gas is admitted into the chamber from the gas supply system 10 through the valves 25. The pressure of the reactive gas in the reaction chamber is 0.001 to 1.0 Torr, e.g. 0.05 Torr. The temperature of the substrates 1 is kept, by means of a suitable temperature controller (not shown), at +450 to -100°C. To the reaction space 6, electric energy is applied from the power sources 15 and 17. The electric energy from the power source 15 is applied between the electrodes 3 and 3' at a frequency of from 1 to 100 MHz, e.g. 13.56 MHz, and at a power level of from 0.5 to 5 KW (equivalent to 0.3 to 3 W/cm), e.g. 1 W (equivalent to 0.6 W/cm). The electric energy from the power source 17 is applied to the substrate holders 2 at a frequency of from 1 to 500 KHz, e.g. 50 KHz, and at a power level of from 100 to 1000 W, e.g. 500 W. The amplitude of the alternating supply outputted from the power source 17 is from 300 to 1000 V. A self-bias voltage of -200 to -600 V appears at the substrate holders 2 during the energy application.

The system of Fig.2 is also suitable for forming carbon coatings having a high degree of hardness. In accordance with experimental results, deposition speeds of from 100 to 200 Å/min were obtained when methane was used and from 500 to 1000 Å/min when ethylene was used. The Vickers hardness and the thermal conductivity were measured and found to be not lower than 2000 Kg/mm$^2$ and not lower than 2.5 W/cm deg respectively.

In another series of experiments, silicon nitride films were deposited on a plurality of substrates 1 by use of an apparatus as shown in Fig.2. The substrates were silicon wafers in which there were formed a plurality of integrated circuits. The silicon nitride films were intended to be final coatings of the wafers. The reactive gas consisted of $Si_2H_6$, ammonia and a carrier gas of nitrogen at a volume ration of 1:3:5. After introduction of the reactive gas at 0.05 Torr, electrical energy from the power sources 15 and 17 were inputted between the electrodes 3' and 3 and to the substrate holders 2 at 13.56 MHz and 800 W and at 50 KHz and 500 W respectively. The voltage applied to the substrate holders was 750 V. The self-bias voltage at the substrate holders was -130 V. As a result, silicon nitride films were deposited on the substrates 1 at 3.1 Å/min. The refractive index of the films was 1.771. The etch rate of the films using an etchant of HF was 3.75 Å/second. Absorption of IR light at 880 cm$^{-1}$ indicative of the existence of the bond Si-N was observed, and there was no light absorption at 1100 cm$^{-1}$ indicative of Si-O. This experiment was repeated with lead frames on which IC chips were mounted and connected thereto by wire bonding. As a result, excellent passivation films were formed.

When it is desired to provide a carbon coating on a glass substrate, pre-coating of the glass with a silicon nitride film in advance of the carbon coating is particularly advantageous. The adhesivity of carbon films to a glass substrate is generally poor because of the interaction between the glass substrate and the carbon film. During long term use, carbon and oxygen contained in the glass substrate may react to produce gaseous COx at the interface and this may cause peeling off of the carbon film from the glass substrate.

In order to provide carbon coatings on a glass substrate with a sturdy mechanical contact, a silicon nitride film is first deposited on the glass substrate in accordance with the preceding example to a thickness of 100 to 1000 Å, and then a carbon coating is deposited on the silicon nitride film in accordance with the foregoing example to a thickness of 0.1 to 1 micron. According to experimental results, no peeling was observed after the carbon films provided on a glass substrate were kept at a relative humidity of 85% and at 85°C for 1000 hours.

Silicon oxide films can be deposited by use of monosilane, $N_2O$ and $N_2$ at a volume ratio of 1:3:10. By application to the electrodes 3 and 3, of electrical energy at 13.56 MHz and to the substrates of electrical energy at 50 KHz, silicon oxide films were deposited at room temperature and at 300 to 1000 Å/min. The etch rate of the films using HF was about 50 Å/sec, which is about 5 times smaller than prior art figures indicating a more resistant film than in the prior art. The IR light absorption spectrum of the films had a peak at 1100 cm$^{-1}$, indicating the existence of Si-O. Other deposition conditions were the same as in the foregoing example for depositing silicon nitride films. After completing wire bonding of IC chips on a lead frame, a silicon oxide film was deposited to a thickness of 0.1 to 1 microns in this manner, followed by plastics moulding thereover. If phosphorous or boron is introduced, phosphorous or boron glass can be deposited.

An important application of the carbon coating process of the present invention is in regard to the photosensitive drum of electrostatic copying machines. A carbon coating of 100 to 500 Å thickness may advantageously be deposited on an organic photoconductive film on the drum at room temperature.

The high thermal conductivity of carbon materials deposited in accordance with the present invention is effective when used as a heat sink. An example of such an application is the provision of a carbon coating on the underside of a silicon semiconductor wafer containing IC chips wherein, after formation of semiconductor devices within the wafer, a carbon film is deposited on the base thereof to a thickness of 0.5 to 5 microns. The wafer is then subjected to tests for examining the electric performance of the chips, the tested wafer is separated into individual chips, and each chip is mounted and electrically connected on a suitable board or a substrate by die bonding or wire bonding.

While several embodiments of the present invention have been described herein it is to be appreciated that the invention is not limited to the particular examples, and that modifications and variations may be made without departure from the scope of the invention as defined in the appended claims. For example, it has been proved effective to add boron, nitrogen, phosphorous or the like into the carbon. Also, when carbon material is being deposited, a halogen gas or halogen compound gas, in addition to a hydrocarbon, is preferably introduced into the reaction chamber. Examples of halogen compound gases are fluorine compounds such as $NF_3$, $SF_3$ and $WF_6$, chlorine compounds such as $CCl_4$, bromine compounds such as $CH_3Br$ and iodine compounds. The carbon material formed in accordance with the present invention may contain a halogen at 0.1-50 atom% which is controlled by adjusting the rate of introduction of the halogen compound gas.

Generally, substrates which can be coated in accordance with the present invention include surfaces made of metals, plastics, organic substances such as PET, PES, PMMA, teflon, epoxy, polyimide and the like, or superconducting ceramics such as $YBaCU_3O_{6-8}$ and $BiSrCaCu_YO_x$ for example.

## Claims

1. A plasma processing apparatus comprising:
a reaction chamber;
a reactive gas supply system;
a vacuum pump for evacuating said reaction chamber;
spaced-apart electrodes provided in said reaction chamber in order to define a reaction space therebetween;
a substrate holder provided in said reaction space;
a first power source for applying AC electrical energy between said electrodes at a frequency for encouraging the generation of a plasma gas therebetween; and
a second power source for applying AC electrical energy to said substrate holder.

2. The apparatus of claim 1 wherein said first power source includes a transformer capable of outputting electrical energy at 1 to 5000 MHz, one terminal of the secondary coil of the transformer being connected to one of said spaced-apart electrodes and the other terminal being connected to the other electrode.

3. The apparatus of claim 2 wherein one output terminal of said second power source is connected to a mid point of said secondary coil and the other terminal of said second power source is connected to said substrate holder.

4. The apparatus of claim 3 wherein the frequency of the electrical energy furnished by the second power source is from 1 to 500 KHz.

5. The apparatus of claim 3 or 4 wherein said mid point is grounded.

6. A method of depositing a thin film coating on a substrate, said method comprising:
disposing a substrate to be coated in a vacuum chamber;
introducing a reactive gas into said vacuum chamber at an appropriate pressure;
producing a plasma gas in said reaction chamber by applying high frequency energy to spaced-apart electrodes between which said substrate has been disposed;
applying alternating electrical energy to said substrate; and
depositing the product of said reactive gas on said substrate by virtue of said alternating electrical energy.

7. The method of claim 6 wherein said plasma gas is generated by applying between said electrodes high frequency electric energy at 1 to 5000 MHz.

8. The method of claim 6 or 7 wherein the frequency of said alternating energy applied to said substrate is 1 to 500 KHz.

9. A CVD method or apparatus for the deposition of thin films onto a substrate in a reaction chamber and wherein spaced-apart electrodes defining a reaction space within the reaction chamber are electrically energized at a frequency of from 1 to 5000 MHz (for example) for establishing a plasma in a reactive gas between the electrodes and the substrate is electrically energized at a frequency of from 1 to 500 KHz (for example) for depositing products of the plasma reaction onto the substrate.

10. A CVD method or apparatus for the deposition of carbon thin films (for example) wherein a plasma developed into a reactive gas is energized at a relatively high frequency (e.g. from 1 MHz to 5 GHz) and a substrate within the plasma space is energized at a relatively low frequency (e.g. from 1 KHz to 500 KHz).

# F I G . 1 (A)

# FIG.1 (B)

# FIG.2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 139 835 (TEGAL CORP.) <br> * Abstract; page 4, line 18 - page 5, lines 2,13-31; page 6, lines 21-31; claims 1,6 * <br> --- | 1,2,4,6 -10 | C 23 C 16/50 <br> H 01 J 37/32 |
| X | US-A-4 585 516 (G.R. CORN et al.) <br> * Column 1, lines 39-50; column 1, line 67 - column 2, line 61; claims 1-3 * <br> --- | 1,2,4,6 -10 | |
| A | US-A-4 572 759 (D.W. BENZING) <br> * Abstract; column 2, lines 34-59; column 4, lines 54-68; claims 1,8,14 * <br> --- | 1,2,4,6 -10 | |
| A | US-A-4 298 419 (K. SUZUKI et al.) <br> * Abstract; column 1, line 65 - column 2, line 17; claims 1-4 * <br> --- | 1,2,4,6 -10 | |
| A | EP-A-0 180 020 (IBM CORP.) <br> * Abstract; claim 1 * <br> ----- | 1,2 | TECHNICAL FIELDS SEARCHED (Int. Cl.4) <br><br> C 23 C <br> H 01 J |

The present search report has been drawn up for all claims

| Place of search | Date of completion of the search | Examiner |
|---|---|---|
| THE HAGUE | 20-06-1989 | JOFFREAU P.O. |

EPO FORM 1503 03.82 (P0401)